Europäisches Patentamt

European Patent Office

Office européen des brevets

(19)

(11) **EP 1 438 787 B1**

(12) **EUROPÄISCHE PATENTSCHRIFT**

(45) Veröffentlichungstag und Bekanntmachung des Hinweises auf die Patenterteilung:
**02.03.2005   Patentblatt 2005/09**

(21) Anmeldenummer: 02762340.4

(22) Anmeldetag: **10.07.2002**

(51) Int Cl.$^7$: **H03H 9/17**

(86) Internationale Anmeldenummer:
**PCT/EP2002/007700**

(87) Internationale Veröffentlichungsnummer:
**WO 2003/032486 (17.04.2003 Gazette 2003/16)**

(54) **BAW-RESONATOR**

BAW RESONATOR

RESONATEUR A ONDE ACOUSTIQUE EN VOLUME

(84) Benannte Vertragsstaaten:
**DE FR GB**

(30) Priorität: **08.10.2001   DE 10149542**

(43) Veröffentlichungstag der Anmeldung:
**21.07.2004   Patentblatt 2004/30**

(73) Patentinhaber: **Infineon Technologies AG
81669 München (DE)**

(72) Erfinder:
• **AIGNER, Robert
82008 - Unterhaching (DE)**
• **HANDTMANN, Martin
81737 München (DE)**

• **MARKSTEINER, Stephan
85640 - Putzbrunn (DE)**
• **NESSLER, Winfried
81739 München (DE)**

(74) Vertreter: **Zimmermann, Tankred Klaus et al
Schoppe, Zimmermann, Stöckeler & Zinkler
Patentanwälte
Postfach 246
82043 Pullach bei München (DE)**

(56) Entgegenhaltungen:
**EP-A- 0 609 555        EP-A- 0 802 628
EP-A- 1 047 189**

**Beschreibung**

Die vorliegende Erfindung bezieht sich auf einen BAW-Resonator (BAW = Bulk Acoustic Wave = akustische Volumenwelle). Ferner bezieht sich die vorliegende Erfindung auf BAW-Filter, die solche BAW-Resonatoren umfassen.

BAW-Filter, die einen oder mehrere BAW-Resonatoren umfassen, beispielsweise in einer Verschaltung von Ladder-Typ, sind im Stand der Technik bekannt. Die für diese BAW-Filter verwendeten BAW-Resonatoren sind sogenannten Dünnfilm-BAW-Resonatoren, d. h., Resonatoren, die einen piezoelektrischen Dünnfilm umfassen. Der Nachteil dieser bekannten BAW-Filter besteht darin, dass keine Filtertopologie bekannt ist, welche eine Signalumwandlung von unsymmetrischen/symmetrischen (unbalanced/balanced) Signalen zu symmetrischen/unsymmetrischen (balanced/ unbalanced) Signalen durchführt, ohne dass Einschränkungen hinsichtlich der Gleichtakt-Lastimpedanz gegenüber Masse eintreten, oder die ohne zusätzliche Spulen oder Transformatoren/Wandler auskommen.

Ein weiterer Nachteil dieser bekannten BAW-Filter besteht darin, dass diese bei Frequenzen von größer als 5 GHz Piezoschichten aufweisen, deren Dicke für eine Grundmoduswelle (Grundmode-BAW) extrem dünn sind (< 300 nm). Ein weiterer Nachteil besteht darin, dass bei solchen Frequenzen von mehr als 5 GHz die Resonatoren, welchen einen vorbestimmten Impedanzpegel aufweisen, kleiner sind, als dies aus Verhaltensgründen (Performance) erwünscht ist, da sich hier beispielsweise ein schlechtes Verhältnis von Fläche zu Umfang der Anordnung ergibt, welche zu starken parasitären Auswirkungen führt.

Wiederum ein weiterer Nachteil der bekannten BAW-Filter besteht darin, dass die Dicke einer Piezoschicht für eine Grundmoduswelle (Grundmode-BAW) bei Frequenzen unterhalb von 500 MHz recht dick sein wird (> 5 µm). Dies führt zu dem weiteren Nachteil, dass unter der Annahme einer dielektrischen Konstante von 10 (des Substrats) ein entsprechender einzelner Resonator mit einem Impedanzpegel von 50 Ohm einen Flächenbedarf von > 0,5 mm$^2$ haben wird.

Zwar sind im Stand der Technik Lösungen bekannt, mittels denen das Problem der Umwandlung von symmetrischen/unsymmetrischen Signalen zu unsymmetrischen/symmetrischen Signalen ermöglicht wird, jedoch weisen auch diese Lösungen die oben genannten Probleme im Zusammenhang mit der Gleichtakt-Lastenimpedanz gegen Masse bzw. mit der Verwendung zusätzlicher Bauelemente auf.

Lösungen für Filteranordnungen für Frequenzen von oberhalb von 5 GHz sind im Stand der Technik bekannt, jedoch werden hierfür typischerweise Hohlraumresonatoren oder Keramikresonatoren verwendet, die beide recht voluminös, elektrisch verlustbehaftet und sehr teuer sind.

Für Frequenzbereiche bis 200 MHz sind im Stand der Technik Quarzkristall-Resonatoren bekannt, deren höchste Betriebsfrequenz heutzutage bei 200 MHz liegt. Filteroperationen im Bereich von 100 MHz bis 2 GHz werden hauptsächlich unter Verwendung von Oberflächenwellenfiltern (SAW-Filtern; SAW = Surface Acoustic Wave) durchgeführt, die den Nachteil haben, dass diese recht voluminös sind und im Bereich von weniger als 500 MHz zusätzlich sehr teuer sind.

Im Stand der Technik sind ferner gestapelte Kristallresonatorstrukturen bekannt. Diesbezüglich wird verwiesen auf den Artikel "Stacked Crystal Filters Implemented with Thin Films" von K.M. Lakin u.a., 43re Annual Symposium on Frequency Control (1989) Seiten 536-543.

Der vorliegenden Erfindung liegt die Erkenntnis zugrunde, dass die eingangs genannten Nachteile bei bekannten BAW-Filtern bzw. bekannten BAW-Resonatoren dadurch vermieden werden können, dass die BAW-Resonatoren piezoelektrische Schichten bzw. Abschnitte in einem piezoelektrischen Material aufweisen, deren Orientierungen zueinander entgegengesetzt (invertiert ausgerichtet) ist. Hierdurch lässt sich zum einen der Bereich der möglichen Anwendungen solcher BAW-Resonatoren deutlich erhöhen, und ferner wird eine Erhöhung der verfügbaren Frequenzbereiche für den Einsatz solcher BAW-Resonatoren ermöglicht.

In einem piezoelektrischen Dünnfilm ist die mechanische Spannung proportional zum anliegenden elektrischen Feld. Der Materialkopplungskoeffizient $k_{mat}$ definiert die Amplitude und das Vorzeichen der Spannung für ein gegebenes elektrisches Feld und umgekehrt. $k_{mat}$ ist direkt mit den Eigenschaften innerhalb der (mono- oder poly-) kristallinen Struktur des Dünnfilms verbunden, wie z. B. der bevorzugten Ausrichtung, der Reinheit und der Korngröße des verwendeten Materials.

Weit verbreitete Materialien für piezoelektrische Dünnfilme sind z. B. AlN oder ZnO$_2$, die auf eine Art und Weise abgeschieden werden können, welche zu polykristallinen Schichten, die eine bevorzugte c-Achsenausrichtung der säulenförmigen Körner, d.h. Orientierung, aufweisen. Die Abscheidungsbedingungen und Aufwachsbedingungen bestimmen, ob die c-Achse nach oben gerichtet ist, oder ob dieselbe nach unten gerichtet ist, wie dies von J.A. Ruffner. u.a. in "Effect of substrate composition on the piezoelectric response of reactivly sputtered AlN thin films" in Thin Solid Films 354, 1999, Seiten 256-261 beschrieben ist.

Bei komplexeren piezoelektrischen (ferroelektrischen) Materialien, wie z. B. PZT (Blei-Zirkonium-Titanat) wird die bevorzugte Ausrichtung (Orientierung), die bei solchen Materialien auch als Polarisation bezeichnet wird, durch einen Polarisationsvorgang eingestellt, der der Abscheidung folgt. Hierbei wird ein hohes elektrisches Feld bei erhöhten Temperaturen an das Material angelegt.

Die Orientierung des Materials der piezoelektrischen Schicht bewirkt, dass die Schicht bei Anliegen eines elektrischen Feldes in einer ersten Richtung, die der Richtung der Orientierung entspricht, kontrahiert, und bei Anliegen eines elektrischen Feldes in einer zweiten Richtung, die der Richtung der Orientierung entgegengesetzt ist, expandiert.

Für die elektrische Antwort eines einfachen BAW-Resonators ist das Vorzeichen von $k_{mat}$ irrelevant, da lediglich $k^2_{mat}$ in den für die elektrische Antwort gültigen Formel auftaucht. Für BAW-Elemente mit mehr als einer piezoelektrischen Schicht in dem akustischen Stapel, wie z. B. gestapelte Kristallfilter, können einige interessante Eigenschaften durch Verwendung von piezoelektrische Schichten mit unterschiedlicher Ausrichtung (umgekehrten Vorzeichen von $k_{mat}$) erreicht werden.

Ein derartiger BAW-Resonator, bestehend aus zwei Schichten piezoelektrischen Materials zwischen Elektrodenschichten, ist aus EP-A-0 609 555 bekannt.

Ausgehend von diesem Stand der Technik liegt der vorliegenden Erfindung die Aufgabe zugrunde, einen verbesserten BAW-Resonator zu schaffen, der ein unsymmetrisches Eingangssignal in ein symmetrisches Ausgangssignal unter Verwendung eines derartigen BAW-Resonators umwandelt.

Diese Aufgabe wird durch eine BAW-Resonator nach Anspruch 1 gelöst.

Bevorzugte Weiterbildungen sind in den Unteransprüchen definiert.

Nachfolgend werden anhand der beiliegenden Zeichnungen bevorzugte Ausführungsbeispiele der vorliegenden Erfindung näher erläutert. Es zeigen:

Fig. 1A einen BAW-Resonator;

Fig. 1B einen BAW-Resonator;

Fig. 2A einen BAW-Resonator mit einer Mehrzahl von piezoelektrischen Schichten mit wechselnder Ausrichtung;

Fig. 2B eine stehende Welle in den piezoelektrischen Schichten des BAW-Resonators aus Fig. 2A;

Fig. 3 ein erstes Ausführungsbeispiel eines erfindungsgemäßen BAW-Resonators;

Fig. 4A ein Ausführungsbeispiel für einen BAW-Resonator mit reduzierter Größe; und

Fig. 4B der Verlauf der Spannung mit Vorzeichen und der elektrischen Felder in den Schichten des BAW-Resonators aus Fig. 4A.

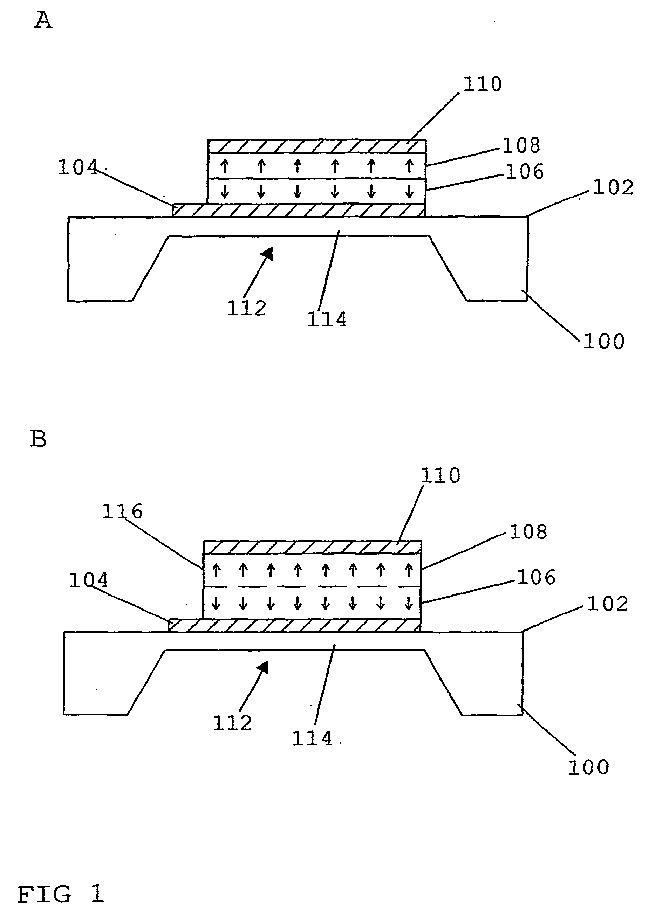

Fig. 1A zeigt einen nicht beanspruchen BAW-Resonator. Der BAW-Resonator umfasst ein Substrat 100 mit einer ersten Hauptoberfläche 102, auf der eine erste Anschlusselektrode 104 aus einem Metall oder einem anderen leitfähigen Material gebildet ist. Auf der Elektrode 104 ist eine erste piezoelektrische Schicht 106 angeordnet, auf der wiederum eine zweite piezoelektrische Schicht 108 angeordnet ist. Auf der piezoelektrischen Schicht 108 ist eine zweite Elektrode 110 aus einem Metall oder einem anderen leitfähigen Material angeordnet. Die erste Elektrode 104 ist beispielsweise eine Eingangselektrode, und die zweite Elektrode 110 ist beispielsweise eine Ausgangselektrode. Das Substrat 100 umfasst eine Ausnehmung 112, um einen Membranbereich 114 zu bilden, auf dem der BAW-Resonator gebildet ist, um eine akustische Entkopplung des Resonators von darunterliegenden Elementen bzw. Schichten zu ermöglichen. Alternativ kann die Entkopplung durch einen sogenannten akustischen Reflektor erreicht werden, der dann zwischen dem Substrat 100 und der Elektrode 104 angeordnet wäre. Sowohl die Entkopplung mittels einer Membran als auch die Entkopplung unter Verwendung eines akustischen Reflektors sind in Fachkreisen bekannt.

Die erste piezoelektrische Schicht 106 wurde derart aufgewachsen, dass die Orientierung des Materials in derselben in Richtung der in Fig. 1A gezeigten Pfeile in der Schicht 106 erfolgt, die Schicht 106 also in diese Richtung polarisiert ist. Die zweite Schicht 108 wurde derart erzeugt, dass die Ausrichtung des Materials in dieser Schicht, also die Polarisierung dieses Materials, in eine Richtung verläuft, die entgegengesetzt zu der Polarisierung in Schicht 106 ist, wie dies durch die entgegengesetzten Pfeile in der Schicht 108 in Fig. 1A zu erkennen ist. Alternativ kann bei ferroelektrischen Materialen die Polarisation der Schichten auch nach dem Aufbringen derselben durch Anlegen eines geeigneten elektrischen Feldes erreicht werden. In diesem Fall sind die piezoelektrischen Schichten 106 und 108 beispielsweise aus PZT Material (Blei-Zirkonium-Titanat) hergestellt. Andernfalls sind die Schichten beispielsweise aus AlN oder $ZnO_2$ hergestellt.

In Fig. 1B ist ein weiterer nicht beanspruches BAW-Resonator dargestellt, welcher sich von dem anhand der Fig. 1A beschriebenen dadurch unterscheidet, dass anstelle der zwei getrennten piezoelektrischen Schichten 106 und 108 ein piezoelektrisches Material 116 zwischen den Elektroden 104 und 110 angeordnet ist. Es ist also nur eine piezoelektrische Schicht 116 vorgesehen. Die Schicht 116 ist jedoch derart hergestellt, dass diese einen ersten Abschnitt 106 und einen zweiten Abschnitt 108 aufweist, in welchem das Material der piezoelektrischen Schicht 116 eine Ausrichtung oder Orientierung (Polarisation) aufweist, die entgegengesetzt zueinander ist, wie dies durch die Pfeile dargestellt ist. Die unterschiedlichen Abschnitte sind durch die gestrichelte Linie in Fig. 1B getrennt.

Die in Fig. 1B gezeigte Schicht 116 ist so hergestellt, dass zunächst der erste Abschnitt 106 aufgewachsen wird, unter Verwendung von Prozessparametern welche die dort gezeigte Ausrichtung ermöglichen. Anschließend wird auf den so erzeugten Abschnitt 106 der zweite Abschnitt 108 unter

Verwendung anderer Prozessparameter aufgewachsen, um die Fig. 1B entgegengesetzte Orientierung in dem Abschnitt 108 zu erreichen. In diesem Fall besteht die piezoelektrische Schicht 116 aus AlN oder ZnO$_2$. Alternativ kann die Schicht 116 auch aus einem ferroelektrischen Material bestehen, bei dem eine Polarisation unter Verwendung des Anlegens eines elektrischen Feldes herbeigeführt wird, wobei in diesem Zusammenhang sichergestellt werden muss, dass nach dem Abscheiden des ersten Abschnitts oder der ersten Schicht 106 und der Polarisierung derselben das Anlegen eines weiteren elektrischen Feldes auf die Gesamtstruktur, um die Schicht 108 zu polarisieren, keine Umpolarisierung des Abschnitts 106 mehr bewirkt.

Die piezoelektrischen Schichten sind derart angeordnet, dass die dieselben akustisch miteinander gekoppelt sind. Die Schichten können aneinander angrenzend oder beabstandet voneinander angeordnet sein, wobei im letztgenannten Fall eine oder mehrere Schichten zwischen denselben vorgesehen sein können.

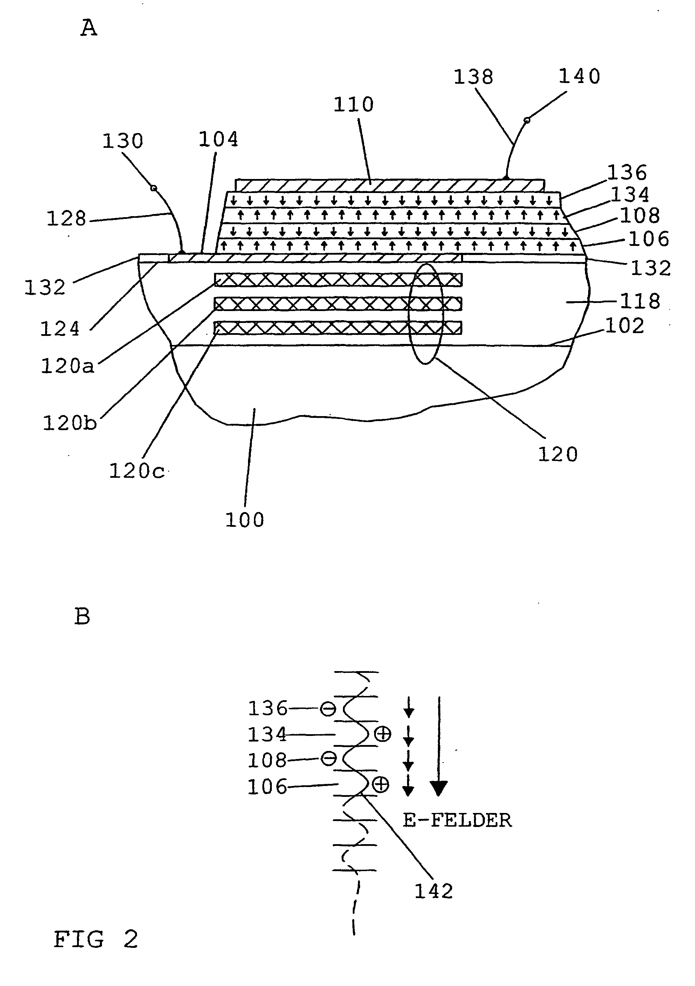

Fig. 2A zeigt einen nicht beanspruchen Hochfrequenzresonator mit einen 1-Tor, der N = 4 piezoelektrische Schichten mit wechselnder Ausrichtung umfasst.

Wie in Fig. 2A gezeigt ist, ist auf einer ersten Hauptoberfläche 102 des Substrats 100 eine Reflektorschicht 118 gebildet, in der ein akustischer Spiegel oder akustischer Reflektor 120 angeordnet ist, der eine Mehrzahl von Einzelschichten 120a bis 120c aufweist, die wechselweise eine hohe akustische. Impedanz und eine niedrige akustische Impedanz umfassen.

Durch den akustischen Reflektor 120 ist die darüber angeordnete BAW-Resonatoranordnung akustisch von dem Substrat entkoppelt. Der beschriebene Reflektor 120 ist in Fachkreisen an sich bekannt, und wird daher nicht näher erläutert.

Auf einer dem Substrat 100 abgewandten Hauptoberfläche 124 der Reflektorschicht 118 ist zumindest teilweise die erste (untere) Elektrode 104 gebildet, die über einen Draht 128 mit einem Anschluss 130 verbindbar ist. Die Bereiche der Hauptoberfläche 124 der Reflektorschicht 118, die nicht durch die erste Elektrode 104 bedeckt sind, sind durch eine isolierende Schicht 132 bedeckt. Die erste piezoelektrische Schicht 106 ist auf der Elektrode 104 und auf einem Abschnitt der Isolationsschicht 132 angeordnet. Auf der ersten piezoelektrischen Schicht 106 ist die zweite piezoelektrische Schicht 108 angeordnet, auf der wiederum eine weitere piezoelektrische Schicht 134 und eine weitere zweite piezoelektrische Schicht 136 angeordnet ist. Wie in Fig. 2A gezeigt ist (siehe die Pfeile in den jeweiligen piezoelektrischen Schichten), sind die Orientierungen der Materialien in den einzelnen Schichten zueinander entgegengesetzt.

Auf der weiteren zweiten piezoelektrischen Schicht 136 ist die zweite (obere) Elektrode 110 angeordnet, die über einen Draht 138 mit einem Anschluss 140 verbindbar ist.

Der BAW-Resonator gemäß Fig. 2A ist in dem Bereich gebildet, in dem sich die untere Elektrode 104 und die obere Elektrode 110 überlappen, und auch über diesen Bereich erstrecken sich die Schichten 120a bis 120c des akustischen Spiegels oder Reflektors 120.

Die in Fig. 2A gezeigte gestapelte Schichtstruktur aus piezoelektrischen Schichten, die alternierende Ausrichtungen aufweisen, ist insbesondere für akustische Volumenwellen bei hohen Frequenzen vorteilhaft. Alternativ zu dem in Fig. 2A gezeigten Resonator können zwischen den einzelnen piezoelektrischen Schichten 106, 108, 134, 136 zusätzliche Metallschichten oder andere Zwischenschichten vorgesehen sein, jedoch ist es nicht zwingend erforderlich, diese Schichten für den Betrieb derselben als Resonator elektrisch zu verbinden. Das in Fig. 2A gezeigte Element hat starke Serienresonanzen und Parallelresonanzen bei Frequenzen, welche der Hälfte der akustischen Wellenlänge in jeder der piezoelektrischen Schicht entsprechen. Der Stapel von piezoelektrischen Schichten zwischen den zwei Elektroden 104 und 110 arbeitet in einem Übermodusbetrieb. Das elektrische Feld hat durch den gesamten Stapel dieselbe Ausrichtung, die wechselnden Orientierungen des Materials stellen jedoch sicher, dass die Kopplung zu diesem Übermodus die stärkste ist, verglichen mit jedem anderen Modus bei einer niedrigeren oder einer höheren Frequenz.

In Fig. 2B ist die stehende Welle 142 gezeigt, die sich in dem Stapel von piezoelektrischen Schichten 106, 108, 134, 136 einstellt. Wie aus Fig. 2B zu erkennen ist, werden die negativen Halbwellen der Spannung durch die invertierte Ausrichtung der piezoelektrischen Schichten 1 und 3 verglichen zu den Schichten 3 und 4, gleichgerichtet. Ferner ist der Verlauf der elektrischen Felder und das Vorzeichen derselben angedeutet. Nachdem die Gesamtdicke des piezoelektrischen Materials zwischen den Elektroden 104 und 110 um den Schichtfaktor N (N = die Anzahl der piezoelektrischen Schichten) größer ist als in einem einfachen Resonator wird das Verhältnis von Oberfläche zu Umfang ebenfalls um den Faktor N erhöht, wodurch sich ein besseres Resonatorverhalten ergibt, da die parasitären Effekte nun reduziert werden können. Anstelle des in Fig. 2A gezeigten Ansatzes, das Element durch den akustischen Spiegel 120 von Substrat zu isolieren, kann dasselbe auch auf einem Membranbereich (siehe Fig. 1) angeordnet sein.

Der Vorteil der in Fig. 2A gezeigten Struktur, welche den akustischen Spiegel 120 verwendet, besteht darin, dass diese akustischen Spiegel 120 einfach herzustellen sind, und bei höheren Frequenzen eine erhöhte Robustheit haben.

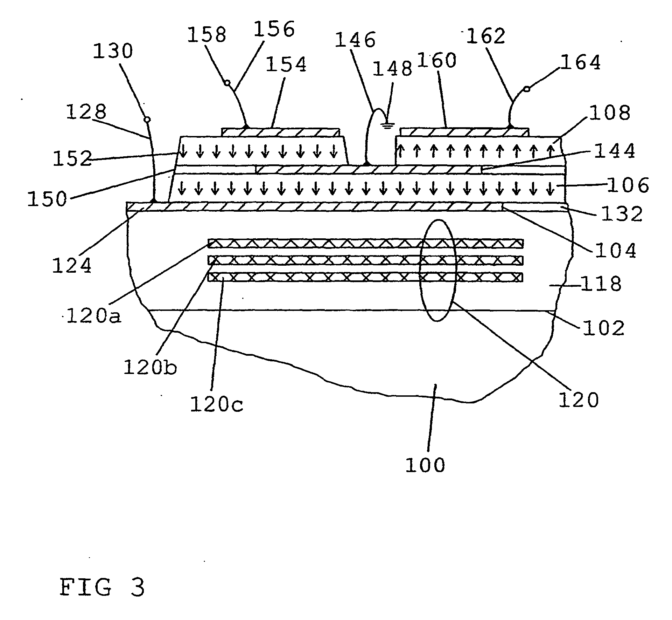

Anhand der Fig. 3 wird nachfolgend ein erstes Ausführungsbeispiel beschrieben, welches eine Umwandlung von symmetrischen/unsymmetrischen zu unsymmetrischen/symmetrischen Signalen ermöglicht. In Fig. 3 werden Elemente, die bereits anhand der Fig. 1 und 2 beschrieben wurden, und die gleiche oder ähnliche Wirkung haben, mit den gleichen Bezugszeichen versehen.

Ähnlich wie in Fig. 2 ist auf der Oberfläche 124 der Reflektorschicht 118 die erste (untere) Elektrode 104 teilweise gebildet, wobei der Abschnitt der Oberfläche 124, der nicht durch die Elektrode 104 aus einem Metall oder einem leitfähigen Material gebildet ist, durch ein isolierendes Material 132 bedeckt ist. Die erste piezoelektrische Schicht 106 ist auf einem Abschnitt der unteren Elektrode 104 sowie auf einem Abschnitt der Isolationsschicht 132 angeordnet. Auf der dem Substrat 100 abgewandten Oberfläche der ersten piezoelektrischen Schicht 106 ist zumindest teilweise eine dritte Elektrode 144 angeordnet, die über einen Draht 146 mit einem Bezugspotential 148, z. B. Masse, verbindbar ist. Diejenigen Abschnitte der dem Substrat 100 abgewandten Oberfläche der ersten piezoelektrischen Schicht 106, die nicht durch die dritte Elektrode 144 bedeckt sind, sind durch ein isolierendes Material 150 bedeckt.

Die zweite piezoelektrische Schicht 108 ist derart auf der ersten piezoelektrischen Schicht 106 angeordnet, dass dieselbe einen Teil derselben überdeckt, wobei die zweite piezoelektrische Schicht 108 zumindest teilweise auf der dritten Elektrode 144 angeordnet ist. Beabstandet von der zweiten piezoelektrischen Schicht 108 ist eine weitere erste piezoelektrische Schicht 152 auf der ersten piezoelektrischen Schicht 106 angeordnet, wobei die weitere erste piezoelektrische Schicht 152 zumindest teilweise auf der dritten Elektrode 144 angeordnet ist. Die zweite piezoelektrische Schicht 108 und die weitere erste piezoelektrische Schicht 152 sind bei dem in Fig. 3 dargestellten Ausführungsbeispiel derart auf der dritten Elektrode 144 und beabstandet voneinander angeordnet, dass der Draht 146 zwischen der zweiten piezoelektrischen Schicht 108 und der weiteren ersten piezoelektrischen Schicht 152 mit der dritten Elektrode verbunden ist.

Auf der weiteren ersten piezoelektrischen Schicht 152 ist zumindest teilweise eine vierte Elektrode 154 angeordnet, die über einen Draht 156 mit einem Anschluss 158 verbindbar ist. Ebenso ist auf der zweiten piezoelektrischen Schicht 108 eine fünfte Elektrode 160 angeordnet, die über einen Draht 162 mit einem Anschluss 164 verbindbar ist.

Durch die in Fig. 3 gezeigte Anordnung ist tatsächlich ein Paar von gestapelten Schichten gebildet, wobei der in Fig. 3 rechts liegende Abschnitt des Elements piezoelektrische Schichten mit entgegengesetzter Orientierung (Polarisation) aufweist, und im Bereich links in Fig. 3 piezoelektrische Schichten mit gleicher Orientierung (Polarisation) aufweist. Die in Fig. 3 gezeigte Struktur kann anstelle des dargestellten akustischen Spiegels 120 auch unter Verwendung einer Membran (siehe Fig. 1) verwendet werden.

Ist der Anschluss 130 ein Eingangsanschluss, und sind die Anschlüsse 158 und 164 zwei Ausgangsanschlüsse, so führt die in Fig. 3 gezeigte Struktur eine Umwandlung von unsymmetrischen Signalen zu symmetrischen Signalen durch, und ferner wird eine Filterung durchgeführt. Ist der Anschluss 130 Ausgangsanschluss, und sind die Anschlüsse 158 und 164 Eingangsanschlüsse, so führt die gezeigte Struktur neben der Filterung noch eine Umwandlung von symmetrischen Signalen zu unsymmetrischen Signalen durch.

Die in Fig. 1 gezeigte Struktur, die ein Paar von gestapelten Resonatoren umfasst, eine gemeinsame Mittelelektrode 144 (Masse) und eine gemeinsamen äußeren Elektrode 104. Die piezoelektrische Schicht unter einer der.verbleibenden Elektroden hat verglichen mit den anderen piezoelektrischen Schichten eine invertierte Orientierung (Polarisation) und erzeugt folglich ein Signal mit einem invertierten Vorzeichen an diesem Ausgang. Die Struktur aus Fig. 3 führt unter der Bedingung, dass gilt

$$k_{mat-108} = -k_{mat-106}$$

eine perfekte Umwandlung eines unsymmetrischen Signals zu einem symmetrischen Signal durch.

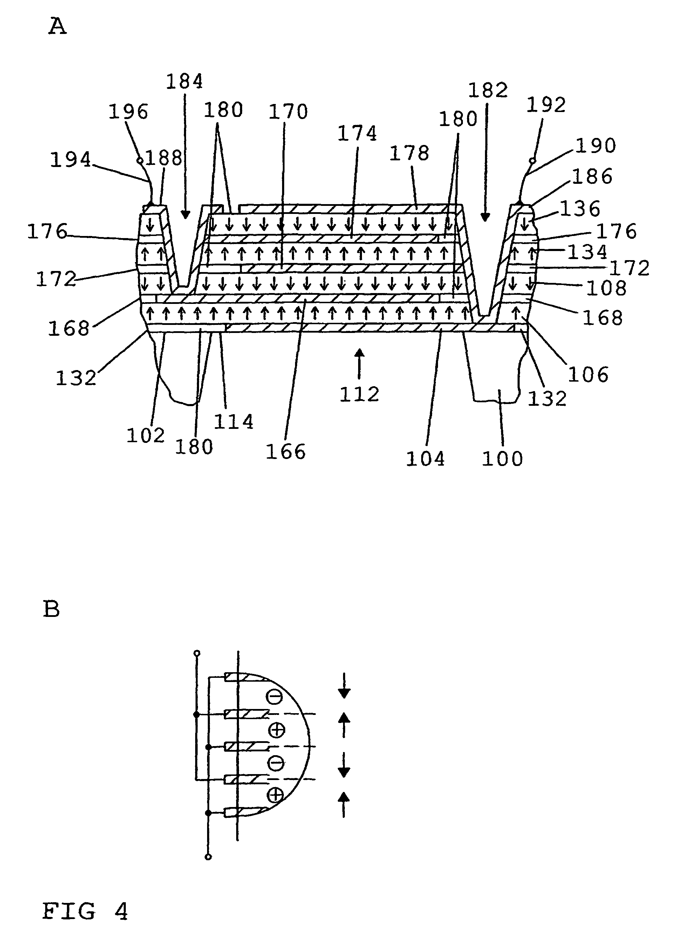

Anhand der Fig. 4 wird nachfolgend ein weiteres Ausführungsbeispiel der vorliegenden Erfindung erläutert, wobei auch hier bereits anhand der vorhergehenden Figuren beschriebene Elemente, die gleiche oder ähnliche Wirkung haben, die gleichen Bezugszeichen haben und nicht erneut beschrieben werden.

In Fig. 4A ist ein Resonator für niedrige Frequenzen gezeigt, der N = 4 piezoelektrische Schichten mit alternierender Orientierung (Polarisation) umfasst. Anders als bei dem vorab beschriebenen Ausführungsbeispiel in Fig. 3 ist die Resonatorvorrichtung hier unter Verwendung des Membran-Ansatzes" (siehe Fig. 1) realisiert. Die Membran 114 umfasst die isolierenden Abschnitte 132 sowie die untere oder erste Elektrode 104, auf der die erste piezoelektrische Schicht 106 gebildet ist. Auf einem Abschnitt der dem Substrat 100 abgewandten Oberfläche der piezoelektrischen Schicht 106 ist eine zweite Elektrode 166 gebildet, und die verbleibenden Abschnitte der dem Substrat 100 abgewandten Oberfläche der piezoelektrischen Schicht 106 sind durch eine Isolationsschicht 168 bedeckt. Auf der zweiten Elektrode 166 und auf der isolierenden Schicht 168 ist die zweite piezoelektrische Schicht 108 gebildet, auf deren freiliegender Oberfläche wiederum eine dritte Elektrode 170 zumindest teilweise gebildet ist. Die verbleibenden Bereiche der freiliegenden Oberfläche der zweiten piezoelektrischen Schicht 108 sind mit einer isolierenden Schicht 172 bedeckt. Auf der dritten Elektrode 170 und der isolierenden Schicht 172 ist eine weitere erste piezoelektrische Schicht 134 gebildet, auf der wiederum teilweise eine vierte Elektrode 174 gebildet ist. Auf den verbleibenden Bereichen der weiteren ersten piezoelektrischen Schicht 134 ist eine isolierende Schicht 176 gebildet. Auf der vierten Elektrode 174 und auf der isolierenden Schicht 176 ist eine weitere zweite piezoelektrische Schicht 136 gebildet, auf deren freiliegender Oberfläche zumindest teilweise eine fünfte Elektrode gebildet ist.

Wie aus Fig. 4A zu erkennen ist, sind die erste Elektrode 104, die dritte Elektrode 170 und die fünfte Elektrode 178 derart gebildet, dass sich dieselben überlappen, wodurch eine erste Elektrodengruppe gebildet ist. Die zweite Elektrode 168 und die vierte Elektrode 174 sind ebenfalls überlappend angeordnet, und bilden eine zweite Elektrodengruppe. Die erste Elektrodengruppe und die zweite Elektrodengruppe ist lediglich teilweise überlappend angeordnet, so dass sich die in Fig. 4A gezeigten Bereiche 180 ohne leitfähiges Material ergeben.

In dem Stapel von piezoelektrischen Schichten 106, 108, 134 und 136 sind zwei Gräben 182 und 184 gebildet die jeweils eine Metallisierung 186 bzw. 188 aufweisen. Die Gräben 182 bzw. 184 sind derart gebildet, dass die darin angeordneten Metallisierungen 186 bzw. 188 mit der ersten Elektrodengruppe (Elektroden 104, 172, 178) bzw. der zweiten Elektrodegruppe (Elektroden 166, 174) verbunden sind, wie dies in Fig. 4A zu erkennen ist.

Die erste Metallisierung 186 ist über einen Draht 190 mit einem Anschluss 192 verbunden. Ebenso ist die zweite Metallisierung 188 über einen Draht 194 mit einem Anschluss 196 verbunden.

Der in Fig. 4A gezeigte BAW-Resonator ist optimiert, um die Größe des Resonators für Anwendungen bei niedrigeren Frequenzen zu reduzieren, oder um extrem niedrige Impedanzpegel zu erlangen. In diesem Fall eines Stapels von einigen piezoelektrischen Schichten mit wechselnder Ausrichtung und vorgesehenen Zwischenelektroden erfolgt ein Resonanzverhalten im fundamentalen Modus oder Grundmodus. Dies wird dadurch erreicht, dass alternierende elektrische Felder an die piezoelektrischen Schichten angelegt werden, was zu einem gleichförmigen Spannungsvorzeichen im gesamten Stapel führt. Elektrisch gesehen existieren N Kondensatoren, die parallel geschaltet sind, was bedeutet, dass entweder die Fläche des Resonators um einen Faktor N oder bei einer im Vergleich zu herkömmlichen Resonatoren konstanten Fläche, die Impedanz um einen Faktor N reduziert wird.

Wie aus Fig. 4B zu erkennen ist, liegen die elektrischen Felder aufgrund der Konfiguration mit den Zwischenelektroden alternierend an, so dass sich ein gleiches Vorzeichen der Spannung durch den gesamten Stapel ergibt. Es wird darauf hingewiesen, dass die Dicke der piezoelektrischen Schichten und Elektroden nicht für alle n Schichten notwendigerweise identisch sein muss. Hinsichtlich der erwünschten Resonatorbandbreite kann eine optimale Lösung existieren, die nicht gleiche Dicken erfordert, was ferner die Einstellung der Spannungsverteilung in dem akustischen Stapel ermöglicht. Anstelle der in Fig. 4A gezeigten Realisierung mittels des "Membran-Ansatzes" kann auch die anhand der Fig. 2 oder 3 beschriebene Realisierung unter Verwendung des akustischen Reflektors verwendet werden.

Die oben beschriebenen Anschlussflächen sind herausgeführte Abschnitte der zugeordneten Elektroden. Die Anschlussflächen haben eine Fläche, die ausreichend ist, um den Draht an denselben zu befestigen.

Anstelle der oben beschriebenen Ausführungsbeispiele zur Kontaktierung der BAW-Resonatoren durch Bonddrähte, sind anderen Kontaktierungsmöglichkeiten bekannt. Die BAW-Resonatoren können beispielsweise in Flip-Chip-Technik mit zugeordneten Kontaktflächen verbunden werden. Andere, im Stand der Technik bekannte Verbindungsverfahren können ebenfalls eingesetzt werden.

Zusätzlich zu den oben beschriebenen Ausführungsbeispielen, bei denen die piezoelektrischen Schichten auf einem Substrat angeordnet sind, kann bei anderen Ausführungsbeispielen eine Gehäusung vorgesehen sein, um den BAW-Resonator vollständig einzuschließen. In diesem Fall ist nicht nur eine akustische Entkopplung zum Substrat hin erforderlich, sondern auch zur Abdeckung hin. Vorzugsweise wird dies dadurch erreicht, dass in dem den BAW-Resonator bedeckenden Abschnitt ein weiterer akustischer Reflektor vorgesehen ist.

Bezugszeichenliste

| | |
|---|---|
| 100 | Substrat |
| 102 | erste Hauptoberfläche des Substrats 100 |
| 104 | erste Elektrode |
| 106 | erste piezoelektrische Schicht |
| 108 | zweite piezoelektrische Schicht |
| 110 | zweite Elektrode |
| 112 | Ausnehmung |
| 114 | Membranbereich |
| 116 | piezoelektrisches Material |
| 118 | Reflektorschicht |
| 120 | akustischer Reflektor |
| 120a-120c | Reflektorschichten |
| 122 | Abschnitt des Reflektors |
| 124 | Hauptoberfläche der Reflektorschicht |
| 126 | erste Elektrode |
| 128 | Draht |
| 130 | Anschluss |
| 132 | isolierende Schicht |
| 134 | weitere erste piezoelektrische Schicht |
| 136 | weitere zweite piezoelektrische Schicht |
| 138 | Draht |
| 140 | Anschluss |
| 142 | stehende Welle |
| 144 | dritte Elektrode |
| 146 | Draht |
| 148 | Bezugspotential |
| 150 | isolierende Schicht |

| | |
|---|---|
| 152 | weitere erste piezoelektrische Schicht |
| 154 | vierte Elektrode |
| 156 | Draht |
| 158 | Anschluss |
| 160 | fünfte Elektrode |
| 162 | Draht |
| 164 | Anschluss |
| 166 | zweite Elektrode |
| 168 | isolierende Schicht |
| 170 | dritte Elektrode |
| 172 | isolierende Schicht |
| 174 | vierte Elektrode |
| 176 | isolierende Schicht |
| 178 | fünfte Elektrode |
| 180 | freiliegender Bereich |
| 182,184 | Gräben |
| 186,188 | Metallisierungen |
| 190 | Draht |
| 192 | Anschluss |
| 194 | Draht |
| 196 | Anschluss |

**Patentansprüche**

1. BAW-Resonator, mit
einer ersten piezoelektrischen Schicht (106) aus einem Material, das in eine erste Richtung orientiert ist, und einer zweiten piezoelektrischen Schicht (108) aus einem Material, das in einer zweiten Richtung, die der ersten Richtung entgegengesetzt ist, orientiert ist, wobei die erste piezoelektrische Schicht (106) und die zweite piezoelektrische Schicht (108) akustisch miteinander gekoppelt sind,
einer ersten Elektrode (104) auf der die erste piezoelektrische Schicht (106) zumindest teilweise gebildet ist;
einer zweiten Elektrode (144), die zumindest teilweise auf der ersten piezoelektrischen Schicht (106) gebildet ist, wobei die zweite piezoelektrische Schicht (108) zumindest teilweise auf einem ersten Abschnitt der zweiten Elektrode (144) angeordnet ist;
einer weiteren ersten piezoelektrischen Schicht (152) die zumindest teilweise auf einem zweiten Abschnitt der zweiten Elektrode (144) angeordnet ist, wobei die zweite piezoelektrische Schicht (108) und die weitere erste piezoelektrische Schicht (152) voneinander beabstandet angeordnet sind wobei die weitere erste piezoelektrische Schicht dieselbe Orientierung aufweist wie die erste Piezoelektrische Schicht.
einer dritten Elektrode (160), die zumindest teilweise auf der zweiten piezoelektrischen Schicht (108) angeordnet ist; und
einer vierten Elektrode (154), die zumindest teilweise auf der weiteren ersten piezoelektrischen Schicht (152) angeordnet ist.

2. BAW-Resonator nach Anspruch 1, mit
einem Substrat (100); und
einem akustischen Reflektor (120), auf dem die piezoelektrischen Schichten angeordnet sind, so dass dieselben akustisch von dem Substrat (100) getrennt sind.

3. BAW-Resonator nach Anspruch 1, mit
einem Substrat (100), das einen Membranbereich (114) aufweist, wobei die piezoelektrischen Schichten auf dem Membranbereich (114) angeordnet sind, so dass dieselben akustisch von dem Substrat (100) getrennt sind.

4. BAW-Resonator nach Anspruch 2, mit einem weiteren akustischen Reflektor, auf dem die piezoelektrischen Schichten angeordnet ist.

5. BAW-Resonator nach einem der Ansprüche 1 bis 4, bei dem die erste Elektrode (104) eine Eingangselektrode, die zweite Elektrode (144) eine Masseelektrode, und die dritte und vierte Elektrode (160, 154) eine erste und zweite Ausgangselektrode sind.

6. BAW-Resonator nach einem der Ansprüche 1 bis 4, bei dem die erste Elektrode (104) eine Ausgangselektrode, die zweite Elektrode (144) eine Masseelektrode, und die dritte und vierte Elektrode (160, 154) eine erste und zweite Eingangselektrode sind.

7. BAW-Resonator nach einem der Ansprüche 1 bis 6, bei dem die Orientierung der ersten und/oder der zweiten piezoelektrischen Schicht (106, 108) beim Erzeugen derselben durch Einstellen der Aufwachsbedingungen festgelegt ist.

8. BAW-Resonator nach einem der Ansprüche 1 bis 7, bei dem die erste und/oder zweite piezoelektrische Schicht (106, 108) aus einem ferroelektrischen Material bestehen, wobei nach dem Erzeugen der piezoelektrischen Schichten durch Anlegen eines geeigneten elektrischen Feldes die Orientierung derselben festgelegt ist.

9. BAW-Filter mit einem oder mehreren BAW-Resonatoren nach einem der Ansprüche 1 bis 8.

**Claims**

1. BAW resonator, comprising
a first piezoelectric layer (106) made of a material oriented toward a first direction and a second piezoelectric layer (108) made of a material oriented toward a second direction opposed to the first direction, the first piezoelectric layer (106) and the second piezoelectric layer (108) being acoustically coupled to each other,

a first electrode (104), on which the first piezoelectric layer (106) is at least partially formed;

a second electrode (144) formed at least partially on the first piezoelectric layer (106), the second piezoelectric layer (108) being at least partially arranged on a first portion of the second electrode (144); and

an additional first piezoelectric layer (152) arranged at least partially on a second portion of the second electrode (144), the second piezoelectric layer (108) and the additional first piezoelectric layer (152) being arranged so as to be spaced apart from each other, the further first piezoelectric layer having the same orientation as the first piezoelectric layer;

a third electrode (160) arranged at least partially on the second piezoelectric layer (108); and

a fourth electrode (154) arranged at least partially on the additional first piezoelectric layer (152).

2. BAW resonator as claimed in claim 1, having

a substrate (100); and

an acoustic reflector (120) having the piezoelectric layers arranged thereon so that same are acoustically disconnected from the substrate (100).

3. BAW resonator as claimed in claim 1, comprising

a substrate (100) having a diaphragm area (114), the piezoelectric layers being arranged on the diaphragm area (114) so that they are acoustically disconnected from the substrate (100).

4. BAW resonator as claimed in claim 2, comprising an additional acoustic reflector on which the piezoelectric layers are arranged.

5. BAW resonator as claimed in any one of claims 1 to 4, wherein the first electrode (104) is an input electrode, the second electrode (144) is a mass electrode, and the third and fourth electrodes (160, 154) are first and second output electrodes.

6. BAW resonator as claimed in any one of claims 1 to 4, wherein the first electrode (104) is an output electrode, the second electrode (144) is a mass electrode, and the third and fourth electrodes (160, 154) are first and second input electrodes.

7. BAW resonator as claimed in any one of claims 1 to 6, wherein the orientation of the first and/or the second piezoelectric layers (106, 108) is specified by setting the growth conditions during the production of the former.

8. BAW resonator as claimed in any one of claims 1 to 7, wherein the first and/or second piezoelectric layer (106, 108) consists of a ferroelectric material, the orientation of same being specified, after producing the piezoelectric layers, by applying a suitable electrical field.

9. BAW filter comprising one or several BAW resonators as claimed in any one of claims 1 to 8.

## Revendications

1. Résonateur à onde acoustique en volume comprenant

une première couche (106) piézoélectrique en un matériau, qui est orienté dans une première direction, et une deuxième couche (108) piézoélectrique en un matériau, qui est orienté dans une deuxième direction opposée à la première direction, la première couche (106) piézoélectrique et la deuxième couche (108) piézoélectrique étant couplées entre elles du point de vue acoustique,

une première électrode (104) formée au moins en partie sur la première couche (106) piézoélectrique;

une deuxième électrode (144), qui est formée au moins en partie sur la première couche (106) piézoélectrique, la deuxième couche (108) piézoélectrique étant disposée au moins en partie sur un tronçon de la deuxième électrode (144);

une autre première couche (152) piézoélectrique, qui est disposée au moins en partie sur un deuxième tronçon de la deuxième électrode (144), la deuxième couche (108) piézoélectrique et l'autre première couche (152) piézoélectrique étant à distance l'une de l'autre, la deuxième couche piézoélectrique ayant la même orientation que la première couche piézoélectrique,

une troisième électrode (160), qui est disposée au moins en partie sur la deuxième couche (108) piézoélectrique; et

une quatrième électrode (154), qui est disposée au moins en partie sur l'autre première couche (152) piézoélectrique.

2. Résonateur à onde acoustique en volume suivant la revendication 1, comprenant

un substrat (100); et

un réflecteur (120) acoustique, sur lequel les couches piézoélectriques sont disposées, de manière à ce que ces couches soient séparées du substrat (100) du point de vue acoustique.

3. Résonateur à onde acoustique en volume suivant la revendication 1, comprenant

un substrat (100), qui a une zone (114) de membrane, des couches piézoélectriques étant disposées sur la zone (114) de membrane, de manière que ces couches soient séparées du substrat (100) du point de vue acoustique.

4. Résonateur à onde acoustique en volume suivant la revendication 2, comprenant un autre récepteur acoustique sur lequel sont disposées les couches piézoélectriques.

5. Résonateur à onde acoustique en volume suivant l'une des revendications 1 à 4, dans lequel la première électrode (104) est une électrode d'entrée, la deuxième électrode (144) est une électrode de masse, et la troisième et la quatrième électrodes (160, 154) sont des première et deuxième électrodes de sortie.

6. Résonateur à onde acoustique en volume suivant l'une des revendications 1 à 4, dans lequel la première électrode (104) est une électrode de sortie, la deuxième électrode (144) est une électrode de masse, et la troisième et la quatrième électrodes (160, 154) sont des première et deuxième électrodes d'entrée.

7. Résonateur à onde acoustique en volume suivant l'une des revendications 1 à 6, dans lequel l'orientation de la première et/ou de la deuxième couche (106, 108) piézoélectrique est fixée lors de leur production en réglant les conditions de croissance.

8. Résonateur à onde acoustique en volume suivant l'une des revendications 1 à 7, dans lequel la première et/ou la deuxième couche (106, 108) piézoélectrique sont en un matériau ferroélectrique, l'orientation des couches piézoélectriques étant fixée après leur production par application d'un champ électrique approprié.

9. Filtre de récepteur à onde acoustique en volume comprenant un ou plusieurs résonateurs à onde acoustique en volume suivant l'une des revendications 1 à 8.

A

B

FIG 1

A

130   104   110                    138        140
                                                      136
128                                                   134
                                                      108
132                                                   106
                                                      132
124                                                   118
120a                                                  102
120b
                                                      120
120c
           100

B

136 —⊖
134 —⊕
108 —⊖
106 —⊕

E—FELDER

142

FIG 2

FIG 3

A

B

FIG 4